# EUROPEAN PATENT SPECIFICATION

(11) **EP 0 489 734 B1**
(45) Date of publication and mention of the grant of the patent: **12.01.1994**
(21) Application number: 90906832.2
(22) Date of filing: 22.05.1990
(51) Int. Cl.: H03K 19/177, H03K 17/693, G11C 7/00, G11C 8/00

(54) **HIGH-SPEED DYNAMIC CMOS CIRCUIT**
SCHNELLE DYNAMISCHE CMOS-SCHALTUNG
CIRCUIT MOS COMPLEMENTAIRE DYNAMIQUE RAPIDE

(30) Priority: 28.08.1989 CA 609627
(43) Date of publication of application: 17.06.1992
(73) Proprietor: NORTHERN TELECOM LIMITED, Ottawa Ontario, KIY 4H7 (CA)
(72) Inventor: ROY, Marc, P., Nepean, Ontario K2J 2L2 (CA)
(74) Representative: Ryan, John Peter William
(86) International application number: CA9000164
(87) International publication number: WO9103876

(56) References cited:
- EP-A- 0 190 823
- US-A- 4 611 133
- US-A- 4 697 105

## Description

### Technical Field

The invention is a high-speed dynamic CMOS circuit, and more particularly, a dynamic CMOS circuit capable of low-power operation at very high speeds in logic array, memory array and multiplexer applications.

### Background Art

The increasing demand for high-speed performance in the major building blocks of VLSI circuits, including memory arrays, programmable logic arrays and multiplexers, has brought about rapid development in circuit techniques. Dynamic CMOS logic has been used successfully in the implementation of these circuits to provide maximum speed capability with low area cost. In programmable logic arrays (PLAs) dynamic CMOS logic is used in both the AND and OR planes to enhance performance. It is also used for the decoder sections of multiplexers and memory arrays.

Dynamic CMOS logic consists of a n-transistor logic structure having an output node which is pre-charged to VDD by a p-transistor (precharge phase) and conditionally discharged by a n-transistor (evaluate phase). It may alternatively consist of a p-transistor logic structure having an output node which is pre-charged to VSS by a n-transistor and conditionally discharged by a p-transistor. In the case of two-plane dynamic CMOS logic PLAs, multiplexers and memory arrays, the output of a n-transistor logic structure input plane is directly connected to a n-transistor logic structure output plane through intermediate logic using a multi-phase clock strategy. The intermediate logic consumes area and slows down the operation of the overall circuit.

The circuit of the invention dispenses with the intermediate logic and the multi-phase clock strategy, and has a correspondingly reduced area and improved speed. The basic gate of the invention consists of a n-transistor logic structure whose output node is discharged to VSS prior to evaluation and is conditionally charged by a p-transistor during evaluation. Programmable logic array, multiplexer and memory array circuits may be configured using the basic gate of the invention.

U.S. Patent No. 4,697,10̸5, which names Thomas H. Moy as inventor and was granted to American Telephone and Telegraph Company, AT&T Bell Laboratories on September 29, 1987, is considered to be the closest prior art to the circuit of the subject invention. That patent discloses a programmable logic array circuit having an AND plane and an OR plane, the circuit being driven by a single clock pulse train and lacking intermediate logic between the two planes.

### Disclosure of Invention

The invention utilizes a two-plane logic array circuit adapted to be operated from a single clock pulse train and having an input plane and an output plane. The input plane is defined by an array of rows and input columns, and the output plane is defined by an array of the rows and at least one output column. A series of first transistors is selectively positioned in the input plane at the intersection of the rows with the input columns such that a charge on one of the input columns results in the discharge of any charge on those rows sharing first transistors with that column. A series of second transistors is selectively positioned in the output plane at the intersection of the rows with the at least one output column such that a charge on one of the rows results in the discharge of any charge on any output column that shares second transistors with that row. The circuit further comprises first, second, third, fourth and fifth gate means. The first gate means allows transmission of each of a first set of input signals to a respective one of the input columns during the first state of each clock pulse. The fifth gate means allows the transmission of the state of the at least one output column to the output of the logic array circuit during the second state of each clock pulse. These features are also present in U.S. Patent No. 4,697,10̸5.

The invention is characterized by the following differences. The second gate means allows the discharge of any charge on the rows during the first state of each clock pulse. The fourth gate means allows pre-charging of the at least one output column during the first state of each clock pulse. The third gate means allows the transmission of each of a second set of input signals to a respective one of the rows during a portion of the second state of each clock pulse. The third gate means is controlled by a secondary pulse train created from the single clock pulse train by a pre-charge circuit that comprises four elements connected in parallel to a central node. Those elements are a capacitor means, a discharge gate means to ground, a charge gate means to a source of charge, and an OR gate means. The central node and single clock pulse train are connected as inputs to the OR gate means. The single clock pulse train controls discharge from the capacitor means through the discharge gate means. The output of the OR gate means controls charging of the capacitor means through the charge gate means and also defines the secondary pulse train.

In one form, the circuit of the invention has application as a programmable logic array circuit in which the second set of input signals are all in a high state and are adapted to charge those rows which do not share first transistors with charged first columns. In another form, the circuit of the invention has application as a multiplexer circuit in which the first set of input signals is utilized for selecting one of the rows and in which the at least one output column is a single output column; in this circuit, the state of that one of the second set of input signals associated with the selected row is passed to the output of the logic array circuit.

The length of the first state of each clock pulse may have a length slightly greater than one-half of the period of the single clock pulse train. The first, second, fourth and fifth gate means may each be open for a time equal to one-half of the period of the single clock pulse train. The third gate means may be open for a time approximating one-eighth of the period of the single clock pulse train.

A third form of the invention is characterized by additional differences. The at least one output column is an even number of output columns and the circuit has a series of memory storage elements. Each storage element is adapted to store data presented in complementary form on a pair of the output columns connected to datalines on the respective memory storage element. The signals input through the first gate means act to address the memory storage elements by selecting rows connected to gates on the datalines on those memory storage elements. Each pair of output columns is connected to the inputs of a respective comparator the output of which passes through the fifth gate means. The fifth gate means is controlled by the single clock pulse train and a read/write control line. Data inputs enter the circuit through a sixth gate means and are then passed in their complementary form through a seventh gate means to the respective pairs of output columns. The sixth gate means is controlled by the single clock pulse train, and the seventh gate means is controlled by the single clock pulse train and the read/write control line. The sixth gate means allows passage of data inputs during the first state of each clock pulse. The fifth and seventh gate means allow passage of data outputs and inputs respectively during the second state of each clock pulse depending on the state of the read/write control line.

The invention will next be described in terms of a preferred embodiment utilizing the accompanying drawings, in which:

### Brief Description of Drawings

Figure 1 is a schematic diagram of a prior art circuit having a pair of dynamic CMOS gates and intermediate logic connecting those gates, the prior art circuit requiring two clock input signals.

Figure 2 is a schematic diagram of a prior art programmable logic array circuit constructed from the dynamic CMOS gates and intermediate logic illustrated in Figure 1.

Figure 3 is a typical timing diagram of the two clock input signals utilized with the circuits of Figures 1 and 2.

Figure 4 is a schematic diagram of a typical circuit used to obtain the two clock input signals required by the circuit of Figures 1 and 2.

Figure 5 is a schematic diagram of a circuit having a pair of dynamic CMOS gates of the invention and a timing signal generator for creating the two clock input signals required by the CMOS gates of the invention.

Figure 6 is a timing diagram of the clock input signals created by the circuit of Figure 5.

Figure 7 is a schematic diagram of a programmable logic array circuit utilizing the dynamic CMOS gates of the invention.

Figure 8 is a schematic diagram of a multiplexer circuit utilizing the dynamic CMOS gates of the invention.

Figure 9 is a schematic diagram of a memory array circuit utilizing the dynamic CMOS gates of the invention.

### Best Mode for Carrying Out the Invention

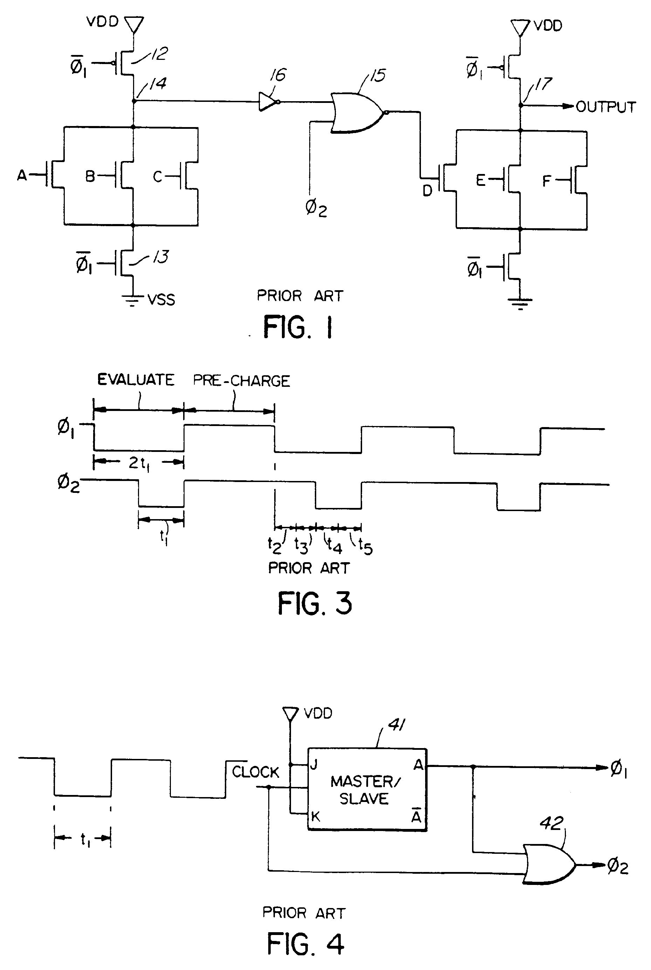

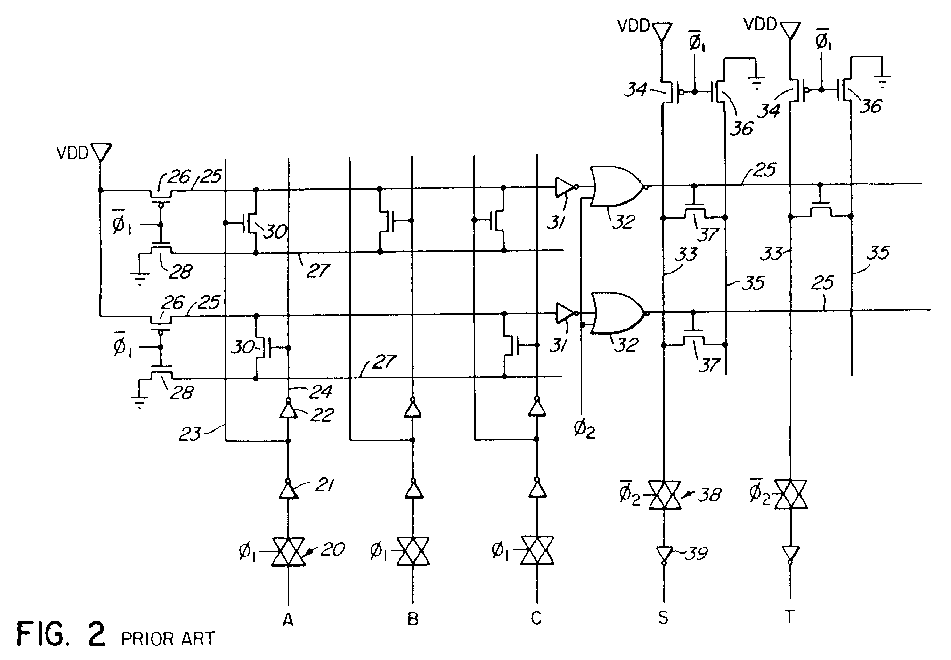

The diagram of Figure 1 is based on a description of a prior art two-phase dynamic CMOS circuit at pages 358 and 359 of 'Principles of CMOS VLSI Design --- A Systems Perspective' by Neil Weste and Kamran Eshraghian (Addison-Wesley Publishing Company, 1985).

The prior art basic dynamic CMOS circuit of Figure 1 has a pre-charge phase occurring when first clock input ø₁ is high. Pre-charge p-transistor 12 opens and n-transistor 13 simultaneously closes. Charge passing through p-transistor 12 then pre-charges node 14. The second clock input ø₂ is maintained high during the pre-charge phase, forcing the output D of NOR gate 15 to maintain a low state irrespective of the state of node 14. The inputs A, B and C are allowed to change during the pre-charge phase, but must remain constant at other times. As clock input ø₁ falls, transistors 12 and 13 close and open, respectively. If any one of the inputs A, B and C is in a high state, the charge on node 14 will discharge to ground; otherwise, node 14 will maintain a high state. The two-phase clocking scheme is set up such that clock input ø₂ will not go low before the state of node 14 has stabilized. The value on node 14 is transferred through inverter 16 to the input of NOR gate 15, and after clock input ø₂ has gone low the value at output D of NOR gate 15 assumes the value on node 14. Node 17 is carrying a charge (having been pre-charged at the same time as node 14), and the value on output D of NOR gate 15, along with the value on inputs E and F, determines the OUTPUT value at node 17 during the evaluate phase (when clock inputs ø₁ and ø₂ are both low).

Figure 2 illustrates a programmable logic array constructed using the two-phase dynamic CMOS logic of Figure 1. The logic array has an AND plane and an OR plane. The AND plane has a series of input gates 20̸, each controlled by the first clock input ø₁ of the two-phase clock. A pair of inverters 21 and 22 are connected serially to the output of each gate 20̸. The outputs of inverters 21 and 22 are connected to an inverted input column line 23 and a non-inverted input column line 24, respectively. The circuit of Figure 2 has a pair of row lines 25 each of which is connected to a power voltage VDD through a pre-charge p-transistor 26. A pair of ground lines 27 are connected to VSS through a series of n-transistors 28. The gate of each pair of transistors 26 and 28 are connected through an inverter (not shown) to first clock input ø₁. A series of first logic transistors 30̸ are each selectively positioned such that its channel extends between a row line 25 and a ground line 27, and its gate is connected to either an inverted column line 23 or a non-inverted column line 24. Each row line 25 is connected to the input of an inverter 31, the output of which is one of the inputs to a two-input NOR gate 32. The other input to each NOR gate 32 is second clock input ø₂. The OR plane has a pair of output column lines 33 each connected to VDD through a p-transistor 34, and has a pair of ground lines 35 each connected to VSS through a n-transistor 36. The gate of each pair of transistors 34 and 36 are connected through an inverter (not shown) to first clock input ø₁. A series of second logic transistors 37 are each selectively positioned such that its channel extends between an output column line 33 and a ground line 35, and its gate is connected to a row line 25. Each output column line 33 is connected to the input of an output gate 38 controlled by second clock input ø₂. The output of each gate 38 then passes through an inverter 39. When each of the input gates 20̸ is open, ie. when clock input ø₁ is high, the state of the three inputs A, B and C appears in inverted form on each of the input column lines 23 and in non-inverted form on each of the input column lines 24. Each of the input column lines 23 and 24 may be connected to the gate of one or more of the first logic transistors 30̸. When one of the input column lines 23 and 24 is in a high state, the first logic transistors 30̸ connected to that column line are turned on to connect a respective row line 25 with the associated ground line 27. During this phase the pre-charge transistors 26 are turned on and the transistors 28 are turned off, so that any row lines 25 and ground lines 27 connected to 'on' logic transistors 30̸ are charged to VDD. The state of the row lines 25 does not affect the OR plane because clock input ø₂ is high. Clock input ø₁ then goes low, the pre-charging of the AND plane and OR plane is terminated, and any row lines 25 connected to 'on' logic transistors 30̸ are discharged. By the time that clock input ø₂ goes low, the input signals have propagated through the AND plane logic. The state of each row line 25 is then passed to the OR plane. Each row line 25 may be connected to the gate of one or more of the second logic transistors 37 in the OR plane, and determines which of the output column lines 33 are discharged to ground through the transistors 36. As an example output of the programmable logic array of Figure 2, the S output would be equal to (A.B.C)+(A.C).

Figure 3 illustrates two typical clock inputs ø₁ and ø₂ used by the circuits of Figures 1 and 2, and Figure 4 illustrates a typical circuit for creating the two clock inputs from an external CLOCK input having a period of 2t₁. The external CLOCK input is fed into a J-K master/slave flip-flop 41 to create clock input ø₁, which has one-half the frequency of the external CLOCK input. The external CLOCK input and clock input ø₁ are fed into an OR gate 42 to form clock input ø₂. With the circuit of Figure 4, clock input ø₂ goes low half-way through the evaluate phase of clock input ø₁. One half of the evaluate phase (equal to the aggregate time t₂+t₃ in Figure 3) is used for stabilizing the AND plane logic before the AND plane output is passed to the OR plane logic. Time t₂ is the time taken for the signal level at node 14 to change in the AND plane, and time t₃ is a time margin added to ensure stability prior to clock input ø₂ going low. Time t₂ is typically made equal to time t₃. The other half of the evaluate phase (equal to the aggregate time t₄+t₅ in Figure 3) is available for passing signals through the OR plane. Time t₄ is the time taken for the signal level at node 17 to change after clock input ø₂ has gone low, and time t₅ is wasted time. This prior art circuit requires two external CLOCK inputs to pass a signal from its input to its output. As will subsequently become evident, the time margin t₃ is not needed with the circuit of the invention, which requires only a single external CLOCK input to pass a signal from its input to its output.

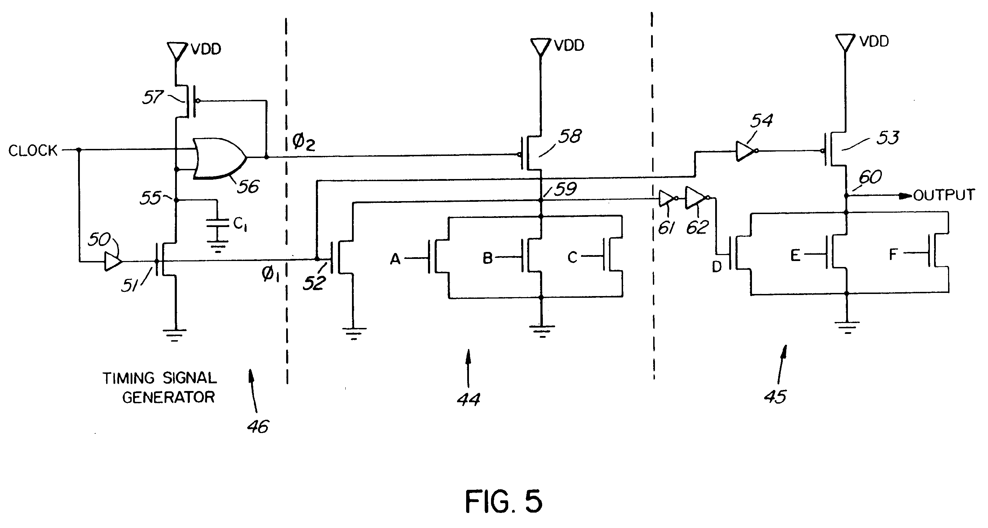

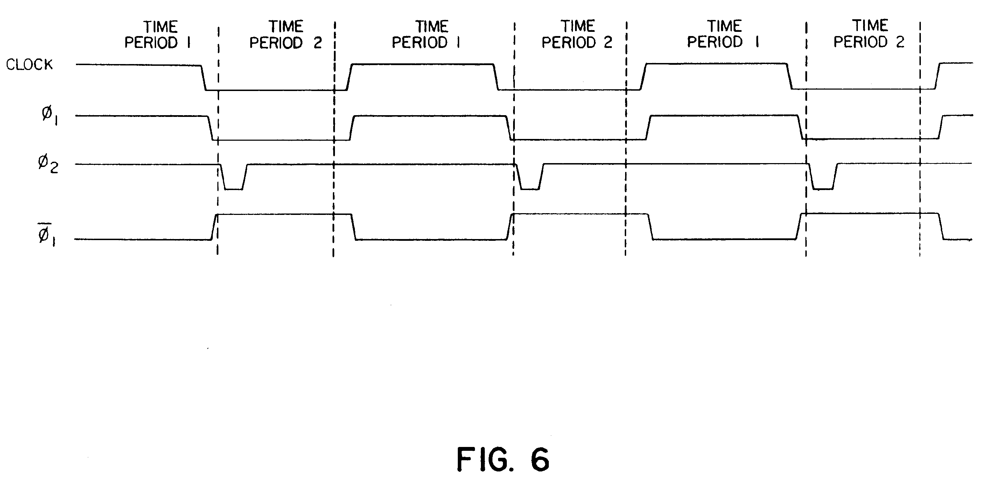

Figure 5 illustrates a basic embodiment of the dynamic CMOS logic circuit of the invention, comprising a pair of basic logic gate circuits 44 and 45 driven by a timing signal generator circuit 46. Figure 6 illustrates the two clock inputs ø₁ and ø₂ created from the external CLOCK input by timing signal generator circuit 46.

The basic embodiment of Figure 5 operates in the following way. Passing the external CLOCK input through driver 50̸ creates the clock input ø₁, and that clock input drives n-transistors 51 and 52, and also drives p-transistor 53 through inverter 54. When the external CLOCK input is high, transistors 51, 52 and 53 are all turned on. Capacitor C₁ discharges through transistor 51, and node 55 drops to a low state. The output of OR gate 56, which is clock input ø₂, is high and transistors 57 and 58 are turned off. Any charge on node 59 is discharged to VSS, while node 60̸ is simultaneously pre-charged to VDD through transistor 53. When the external CLOCK input goes low, transistors 51, 52 and 53 turn off. OR gate 56 has two low inputs, and clock input ø₂ goes low. Pre-charge transistors 57 and 58 turn on, and capacitor C₁ starts to charge. Capacitor C₁ is sized so as to ensure that clock input ø₂ remains low a sufficient time for charge passing through transistor 58 to evaluate logic gate circuit 44; that time is typically in the order of one-eighth of the period of the external CLOCK input. After capacitor C₁ has charged, one input of OR gate 56 is high; clock input ø₂ then goes high and the transistors 57 and 58 turn off. The logic inputs A, B and C are evaluated while transistor 58 is on. If one of those inputs is high, node 59 assumes the ground state; otherwise, node 59 assumes a high state. Node 59 is connected to input D of the OR plane as shown in Figure 5, and would normally also be connected to the inputs of other logic gate circuits 45. In order to minimize the load capacitance on node 59, the output of logic gate circuit 44 is normally buffered by a pair of drive inverters 61 and 62. Input D propagates with inputs E and F through circuit 45 to create an OUTPUT value. When the external CLOCK input returns high, transistors 51, 52 and 53 turn on, clock input ø₂ is not affected, and the process earlier described is repeated. The circuit of the invention does not require the time margin of the prior art circuit, and the time required for signals to pass from the input of circuit 44 to the output of circuit 45 is equal to the period of one external CLOCK cycle, ie. half of the time required for signal propagation through the prior art circuit.

The designations TIME PERIOD 1 and TIME PERIOD 2 have been placed in Figure 6 to assist in describing the relationship between clock inputs ø₁ and ø₂. Although the aggregate of TIME PERIOD 1 and TIME PERIOD 2 is equal to the period of the external CLOCK input, TIME PERIOD 2 is slightly shorter than TIME PERIOD 1.

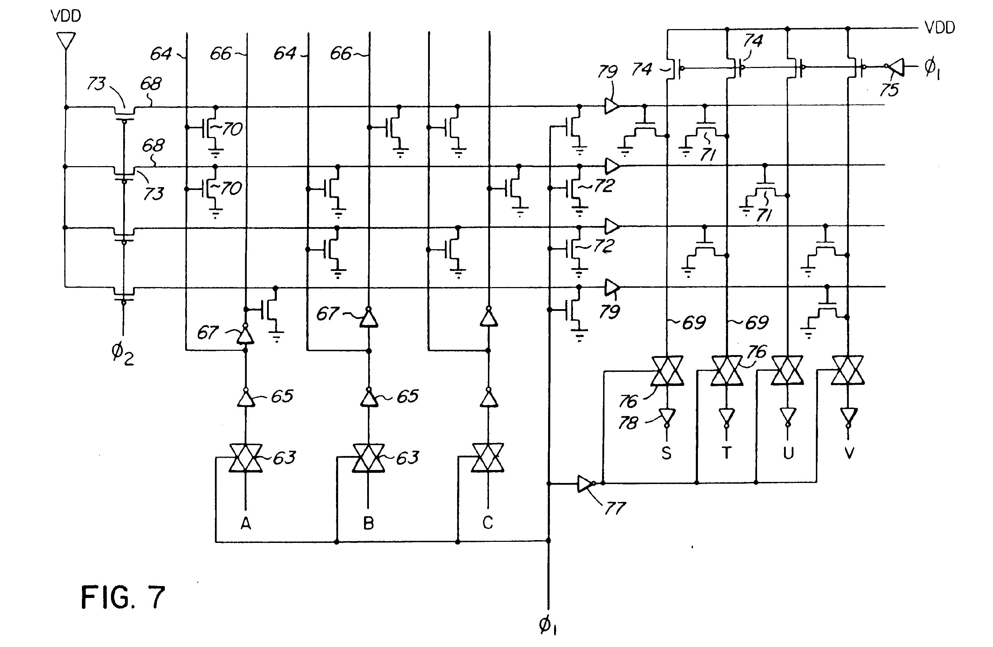

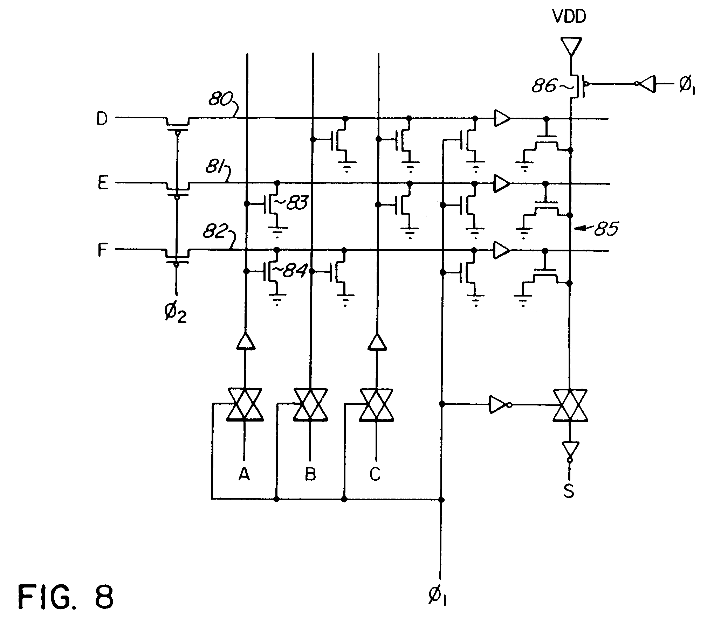

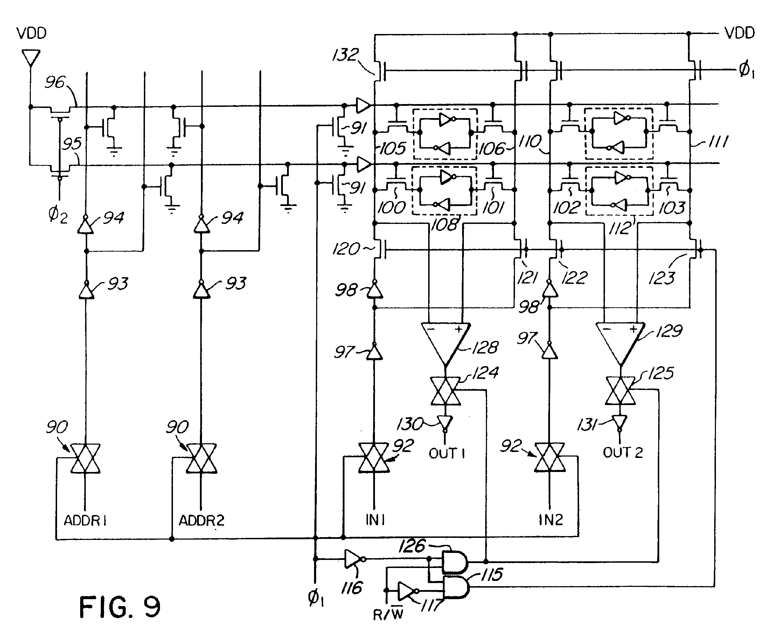

Figures 7, 8 and 9 illustrate three circuits embodying the clocking scheme of the invention. All three circuits utilize a signal generator circuit corresponding to circuit 46. Figure 7 is a diagram of a programmable logic array circuit having logic comparable to that in the prior art circuits of Figures 2. Figure 8 is a diagram of a multiplexer circuit, and Figure 9 is a diagram of a memory circuit.

With respect to the programmable logic array circuit of Figure 7, each of the inputs A, B and C is fed into an input transmission gate 63 controlled by clock input ø₁. The output of gate 63 is connected to an inverted input column line 64 through a first inverter 65. The output of first inverter 65 is connected to a non-inverted input column line 66 through a second inverter 67. The circuit of Figure 7 has a series of input column lines 64 and 66, row lines 68, output column lines 69, first logic transistors 70̸ and second logic transistors 71 similar to those earlier described with respect to Figure 2. The circuit of Figure 7 also has a series of transistors 72 each having its channel extending between one of the row lines 68 and VSS and having its gate connected to clock input ø₁. Charge passes from VDD to the row lines 68 through a series of transistors 73 each having its gate connected to clock input ø₂. Charge passes from VDD to the output column lines 69 through a series of transistors 74 each having its gate connected to clock input ø₁ through an inverter 75. Each of the output column lines is connected to an output transmission gate 76 controlled by clock input ø₁ through an inverter 77. The outputs of the gates 76, when inverted by a series of inverters 78, represent the output of the programmable logic array circuit.

The programmable logic circuit of Figure 7 operates in the following way. When clock input ø₁ goes high, the state of the inputs A, B and C are placed on the respective input column lines 64 and 66, any charge on the row lines 68 is discharged through the transistors 72, and the state of the outputs on the inverters 78 becomes the outputs S, T, U and V. Clock input ø₁ then goes low, preventing any change on the inputs A, B and C from affecting the input column lines 64 and 66, and turning off the transistors 72. The transistors 74 turn off, terminating the pre-charging of the output column lines 69. Clock input ø₂ then goes low for a short time, allowing each of the transistors 73 to pass charge from VDD. The charge is retained on those row lines 68 which are connected to first logic transistors 70̸ that are all in the 'off' state. The state of the row lines 68 determines which of the output column lines 69 retain their charge, a high state on a row line 68 resulting in the second logic transistors connected to that row line discharging the charge from any connected output column lines 69. Since each of the gates 76 is open, the state of the output column lines 69 appears inverted at the output of the inverters 78. When clock input ø₁ goes high, the process repeats. As with the basic circuit of Figure 5, a buffer means must be placed between the output of the AND plane and the input of the OR plane. Each driver 79 in Figure 7 is formed from a pair of drive inverters having a construction and function corresponding with the inverters 61 and 62 earlier described with respect to Figure 5.

The multiplexer circuit of Figure 8 operates in a similar fashion. With this circuit, the inputs A, B and C each act to select one of the row lines 80̸, 81 or 82, respectively. For instance, an (A,B,C) value of (1,0̸,0̸) selects row line 80̸. When clock input ø₂ goes high, the state of the D input is maintained on row line 80̸. The state of the E and F inputs are not retained on row lines 81 and 82, because an (A,B,C) value of (1,0̸,0̸) results in any charge that enters row lines 81 and 82 being dissipated through transistors 83 and 84. The state of row line 80̸ determines the state of the output column line 85 after pre-charging through transistor 86. If row line 80̸ is high, output column line 85 goes low; if row line 80̸ is low, output column line 85 stays high. The state of the S output is the inverse of the state of output column 85. If (A,B,C) has the value (0̸,1,0̸), the S output will assume the value on the E input after one cycle of the external CLOCK input.

With respect to the memory circuit of Figure 9, the pairs of gates 90̸, 91 and 92 are open when clock input ø₁ is high. The pair of gates 90̸ pass the address selection values (ADDR1,ADDR2) to the pairs of inverters 93 and 94. An (ADDR1,ADDR2) value of (1,1) selects row line 95, and an (ADDR1,ADDR2) value of (0̸,0̸) selects row line 96. With clock input ø₁ high, the pair of gates 91 are open for grounding row lines 95 and 96, and the pair of gates 92 pass input data values IN1 and IN2 to the pairs of inverters 97 and 98.

After clock input ø₁ goes low, clock input ø₂ goes low and then high. If row line 95 is selected, it remains in a high state after clock input ø₂ returns high. A high state on row line 95 results in the opening of transistors 10̸0̸, 10̸1, 10̸2 and 10̸3. During a write operation, the complementary state of the output column lines 10̸5 and 10̸6 will determine the state of the storage unit 10̸8, and the complementary state of the output column lines 110̸ and 111 will determine the state of storage unit 112. If the READ/WRITE (R/W) input is low (for a write cycle), the output of AND gate 115 goes high when clock input ø₁ goes low (that clock input and R/W input being inverted by the inverters 116 and 117, respectively). Transistors 120̸, 121, 122, and 123 are then in an open condition. Transmission gates 124 and 125 will remain closed during the time that the R/W input is low since the output of AND gate 126 remains in a low state during that time. With transistors 10̸0̸, 10̸1, 10̸2, 10̸3, 120̸, 121, 122 and 123 all 'on', the values on the pairs of inverters 97 and 98 are passed to the storage units 10̸8 and 112. The former value on each of the storage units 10̸8 and 112 is either maintained or is 'flipped'. As clock input ø₁ returns high, the transistors 10̸0̸, 10̸1, 10̸2, 10̸3, 120̸, 121, 122 and 123 are turned off, and the values on storage units 10̸8 and 112 can no longer be affected. If the R/W input is high (for a read cycle), the output of AND gates 115 and 126 go low and high, respectively, as clock input ø₁ goes low. Transistors 120̸, 121, 122 and 123 thereby remain closed throughout the read cycle. Transistors 10̸0̸, 10̸1, 10̸2 and 10̸3 and transmission gates 124 and 125 are open during that portion of the read cycle in which clock cycle ø₁ is low. The values on storage units 10̸8 and 112 are passed to the respective pairs of inputs of comparators 128 and 129, respectively, and appear at the output of inverters 130̸ and 131, respectively. Those outputs, designated as OUT1 and OUT2 in Figure 9, are unaffected by the return of clock input ø₁ to the high state. Each of the transistors 132 is a NMOS transistor driven by the clock input ø₁ directly; in contrast, each of the corresponding pre-charge transistors in the circuits of Figures 7 and 8 is a PMOS transistor driven by the inverted clock input ø₁. The difference results from the fact that the noise margins required on the output column lines of the circuits of Figures 7 and 8 are not required for the circuit of Figure 9 because of the presence of comparators 128 and 129. For proper performance of the memory circuit, the R/W input should not change its state during the time that the external CLOCK input is in the low state.

### Industrial Applicability

The programmable logic array, multiplexer and memory circuits that have been described are all capable of operating with the single-phase clock input. Very high clock speeds (in the order of 10̸0̸ MHz with existing technology) may be used with these circuits.

## Claims

1. A two-plane logic array circuit adapted to be operated from a single clock pulse train and having an input plane and an output plane, the input plane being defined by an array of rows (68) and input columns (64,66), the output plane being defined by an array of the rows (68) and at least one output column (69), a series of first transistors (70̸) being selectively positioned in the input plane at the intersection of the rows (68) with the input columns (64,66) such that a charge on one of the input columns (64,66) results in the discharge of any charge on those rows (68) sharing first transistors with that column (64,66), a series of second transistors (71) being selectively positioned in the output plane at the intersection of the rows (68) with the at least one output column (69) such that a charge on one of the rows (68) results in the discharge of any charge on any output column (69) that shares second transistors (71) with that row (68), the circuit further comprising first (63), second (72), third (73), fourth (74) and fifth (76) gate means, the first gate means (63) allowing the transmission of each of a first set of input signals to a respective one of the input columns (64,66) during the first state of each clock pulse, the fifth gate means (76) allowing the transmission of the state of the at least one output column (69) to the output of the logic array circuit during the second state of each clock pulse,
CHARACTERIZED in that the second gate means (72) allows the discharge of any charge on the rows (68) during the first state of each clock pulse, the fourth gate means (74) allows the pre-charging of the at least one output column (69) during the first state of each clock pulse, and the third gate means (73) allows the transmission of each of a second set of input signals to a respective one of the rows (68) during a portion of the second state of each clock pulse, the third gate means (73) being controlled by a secondary pulse train created from the single clock pulse train by a pre-charge circuit (46), the pre-charge circuit (46) comprising four elements connected in parallel to a central node (55), those elements being a capacitor means (C₁), a discharge gate means (51) to ground, a charge gate means (57) to a source of charge, and an OR gate means (56), the central node (55) and single clock pulse train being connected as inputs to the OR gate means (56), the single clock pulse train controlling discharge from the capacitor means (C₁) through the the discharge gate means (51), the output of the OR gate means (56) controlling charging of the capacitor means (C₁) through the charge gate means (57) and also defining the secondary pulse train.

2. A circuit as in claim 1, wherein the second set of input signals are all in a high state and are adapted to charge those rows (68) which are not sharing first transistors (70̸) with charged input columns (64,66).

3. A circuit as in claim 1, wherein the first set of input signals are utilized for selecting one of the rows (80̸,81,82) and wherein the at least one output column is a single output column (85), the circuit acting as a multiplexer for passing the state of that one of the second set of input signals associated with the selected row to the output of the logic array circuit.

4. A circuit as in claim 1, wherein the length of the first state of each clock pulse is slightly greater than one-half of the period of the single clock pulse train.

5. A circuit as in claim 1, wherein the first (63), second (72), fourth (74), and fifth (76) gate means are each open for a time equal to one-half of the period of the single clock pulse train.

6. A circuit as in claim 1, wherein the third gate means (73) is open for a time approximating one-eighth of the period of the single clock pulse train.

7. A circuit as in claim 1,
FURTHER CHARACTERIZED in that the at least one output column is an even number of output columns (10̸5,10̸6; 110̸,111) and the circuit has a series of memory storage elements (10̸8) each adapted to store data presented in complementary form on a pair of the output columns connected to datalines on the respective memory storage element (10̸8), the signals input through the first gate means (90̸) act to address the memory storage elements (10̸8) by selecting rows (95,96) connected to gates (10̸0̸,10̸1; 10̸2,10̸3) on the datalines on those memory storage elements (10̸8), each pair of output columns (10̸5,10̸6; 110̸,111) is connected to the inputs of a respective comparator (128,129) the output of which passes through the fifth gate means (124,125), the fifth gate means (124,125) is controlled by the single clock pulse train and a read/write control line, data inputs enter the circuit through a sixth gate means (92) and are then passed in their complementary form through a seventh gate means (120̸,121; 122,123) to the respective pairs of output columns (10̸5,10̸6; 110̸,111), the sixth gate means (92) is controlled by the single clock pulse train and the seventh gate means (120̸,121; 122,123) is controlled by the single clock pulse train and the read/write control line, the sixth gate means (92) allows passage of data inputs during the first state of each clock pulse, the fifth (124,125) and seventh (120̸,121; 122,123) gate means allow passage of data outputs and inputs respectively during the second state of each clock pulse depending on the state of the read/write control line.

## Patentansprüche

1. Zwei-Ebenen-Logikanordnungs-Schaltung, die an einer einzigen Taktimpulsfolge betreibbar ist und eine Eingangsebene und eine Ausgangsebene aufweist, bei der Eingangsebene durch eine Anordnung von Reihen (68) und Eingangsspalten (64,66) definiert ist, während die Ausgangsebene durch eine Anordnung der Reihen (68) und zumindestens einer Ausgangsspalte (69) definiert ist, bei der eine Reihe von ersten Transistoren (70) selektiv in der Eingangsebene an den Schnittpunkten der Reihen (68) mit den Eingangsspalten (64,66) derart angeordnet ist, daß eine Ladung auf einer der Eingangsspalten (64,66) zu einer Entladung irgendeiner Ladung auf denjenigen Reihen führt, die sich erste Transistoren mit dieser Spalte (64,66) teilen, bei der eine Reihe von zweiten Transistoren selektiv in der Ausgangsebene an den Schnittpunkten der Reihen (68) mit der zumindestens einen Ausgangsspalte (69) derart angeordnet ist, daß eine Ladung auf einer der Reihen (68) zu der Entladung irgendeiner Ladung auf irgendeiner Ausgangsspalte (69) führt, die sich zweite Transistoren (71) mit dieser Reihe (68) teilt, wobei die Schaltung weiterhin erste (63), zweite (72), dritte (73), vierte (74) und fünfte (76) Gattereinrichtungen umfaßt, von denen die erste Gattereinrichtung (63) die Übertragung jedes eines ersten Satzes von Eingangssignalen an eine jeweilige der Eingangsspalten (64,66) während des ersten Zustandes jedes Taktimpulses ermöglicht, während die fünfte Gattereinrichtung (76) die Übertragung des Zustandes der zumindestens einen Ausgangsspalte (69) an den Ausgang der Logikanordnungs-Schaltung während des zweiten Zustandes jedes Taktimpulses ermöglicht,
dadurch gekennzeichnet, daß die zweite Gattereinrichtung (72) die Entladung irgendeiner Ladung auf den Reihen (68) während des ersten Zustandes jedes Taktimpulses ermöglicht, daß die vierte Gattereinrichtung (74) die Voraufladung der zumindestens einen Ausgangsspalte (69) während des ersten Zustandes jedes Taktimpulses ermöglicht, daß die dritte Gattereinrichtung (73) die Übertragung jedes eines zweiten Satzes von Eingangssignalen an eine jeweilige der Reihen (68) während eines Teils des zweiten Zustandes jedes Taktimpulses ermöglicht, daß die dritte Gattereinrichtung (73) durch eine sekundäre Impulsfolge gesteuert ist, die aus der einzigen Taktimpulsfolge durch eine Voraufladeschaltung (46) geschaffen wird, daß die Voraufladeschaltung (46) vier Elemente umfaßt, die parallel mit einem zentralen Knoten verbunden sind, wobei diese Elemente ein Kondensatorelement (C₁), eine Entladegattereinrichtung (51) gegen Erde, eine Ladegattereinrichtung (57) zu einer Ladungsquelle und eine ODER-Gattereinrichtung (56) sind, wobei der zentrale Knoten (55) und die einzige Taktimpulsfolge als Eingänge mit der ODER-Gattereinrichtung (56) verbunden sind und die einzige Taktimpulsfolge die Entladung von dem Kondensatorelement (C₁) durch die Entladegattereinrichtung (51) steuert und wobei der Ausgang der ODER-Gattereinrichtung (56) die Ladung des Kondensatorelementes (C₁) durch die Ladegattereinrichtung (57) steuert und weiterhin die sekundäre Impulsfolge definiert.

2. Schaltung nach Anspruch 1, bei der die Eingangssignale des zweiten Satzes von Eingangssignalen alle einen hohen Zustand aufweisen und in der Lage sind, die Reihen (68) zu laden, die sich keine erste Transistoren (70) mit geladenen Eingangsspalten (64,66) teilen.

3. Schaltung nach Anspruch 1, bei der der erste Satz von Eingangssignalen zur Auswahl einer der Reihen (80,81,82) verwendet wird, und bei der die zumindestens eine Ausgangsspalte eine einzelne Ausgangsspalte (65) ist, wobei die Schaltung als Multiplexer wirkt, um den Zustand des einen des zweiten Satzes von Eingangssignalen, das der ausgewählten Reihe zugeordnet ist, zum Ausgang der Logikanordnungs-Schaltung weiterzuleiten.

4. Schaltung nach Anspruch 1, bei der die Länge des ersten Zustandes jedes Taktimpulses geringfügig größer als eine Hälfte der Periode der einzigen Taktimpulsfolge ist.

5. Schaltung nach Anspruch 1, bei der die ersten (63), zweiten (72), vierten (74) und fünften (76) Gattereinrichtungen jeweils für eine Zeit offen sind, die gleich einer Hälfte der Periode der einzigen Taktimpulsfolge ist.

6. Schaltung nach Anspruch 1, bei der die dritte Gattereinrichtung (73) für eine Zeit geöffnet ist, die einem Achtel der Periode der einzigen Taktimpulsfolge angenähert ist.

7. Schaltung nach Anspruch 1,
dadurch gekennzeichnet, daß die zumindestens eine Ausgangsspalte durch eine geradzahlige Anzahl von Ausgangsspalten (105,106;110, 111) gebildet ist, daß die Schaltung eine Reihe von Speicherelementen (108) aufweist, die jeweils zur Speicherung von Daten ausgebildet sind, die in komplementärer Form an einem Paar der Ausgangsspalten geliefert werden, die mit Datenleitungen an dem jeweiligen Speicherelement (108) verbunden sind, daß die durch die erste Gattereinrichtung (90) hindurch eingegebenen Signale eine Adressierung der Speicherelemente (108) durch Auswahl von Reihen (95,96) bewirken, die mit Gattern (100,101;102,103) an den Datenleitungen an diesen Speicherelementen (108) verbunden sind, daß jedes Paar von Ausgangsspalten (105,106;110,111) mit den Eingängen eines jeweiligen Vergleichers (128,129) verbunden ist, dessen Ausgang die fünften Gattereinrichtungen (124,125) durchläuft, daß die fünfte Gattereinrichtung (124,125) durch die einzige Taktimpulsfolge und eine Lese-/Schreibsteuerleitung gesteuert ist, daß Dateneingänge in die Schaltung über eine sechste Gattereinrichtung (92) eintreten und dann in ihrer komplementären Form durch eine siebte Gattereinrichtung (120, 121;122,123) an die jeweiligen Paare von Ausgangsspalten (105, 106;110,111) geleitet werden, daß die sechste Gattereinrichtung (92) durch die einzige Taktimpulsfolge gesteuert ist, während die siebte Gattereinrichtung 8120,121;122,123) durch die einzige Taktimpulsfolge und die Lese-/Schreib-Steuerleitung gesteuert ist, daß die sechste Gattereinrichtung (92) das Hindurchlaufen der Dateneingänge während des ersten Zustandes jedes Taktimpulses ermöglicht, und daß die fünften (124,125) und siebten (120,121;122,123) Gattereinrichtungen das Hindurchlaufen der Datenausgänge bzw. Eingänge während des zweiten Zustandes jedes Taktimpulses in Abhängigkeit von dem Zustand der Lese-/Schreibsteuerleitung ermöglichen.

## Revendications

1. Circuit à réseau logique à deux plans, destiné à travailler avec un seul train d'impulsions d'horloge et ayant un plan d'entrée et un plan de sortie, le plan d'entrée étant délimité par une matrice de lignes (68) et de colonnes d'entrée (64, 66), le plan de sortie étant délimité par une matrice de lignes (68) et d'au moins une colonne de sortie (69), une série de premiers transistors (70) étant positionnée sélectivement dans le plan d'entrée à l'intersection des lignes (68) avec les colonnes d'entrée (64, 66) afin qu'une charge de l'une des colonnes d'entrée (64, 66) provoque la décharge d'une charge éventuelle dans les lignes (68) qui partagent les premiers transistors avec cette colonne (64, 66), des seconds transistors (71) d'une autre série étant positionnés sélectivement dans le plan de sortie à l'intersection des lignes (68) avec la colonne de sortie au moins (69) afin qu'une charge de l'une des lignes (68) provoque la décharge d'une charge éventuelle de l'une quelconque des colonnes de sortie (69) qui partagent les seconds transistors (71) avec cette ligne (68), le circuit comprenant en outre un premier (63), un second (72), un troisième (73), un quatrième (74) et un cinquième (76) dispositif à porte, le premier dispositif à porte (63) permettant la transmission de chaque signal d'entrée d'un prémier ensemble à une colonne respective parmi les colonnes d'entrée (64, 66) pendant le premier état de chaque impulsion d'horloge, le cinquième dispositif à porte (76) permettant la transmission de l'état de la colonne de sortie au moins (69) à la sortie du circuit à réseau logique pendant le second état de chaque impulsion d'horloge,
caractérisé en ce que le second dispositif à porte (72) permet la décharge d'une charge éventuelle des lignes (68) pendant le premier état de chaque impulsion d'horloge, le quatrième dispositif à porte (74) permet la charge préalable de la colonne de sortie au moins (69) pendant le premier état de chaque impulsion d'horloge, et le troisième dispositif à porte (73) permet la transmission de chaque signal d'un second ensemble de signaux d'entrée à une ligne respective parmi les lignes (68) au cours d'une partie du second état de chaque impulsion d'horloge, le troisième dispositif à porte (73) étant commandé par un train secondaire d'impulsions créé à partir du train unique d'impulsions d'horloge par un circuit (46) de charge préalable, ce circuit (46) de charge préalable comprenant quatre éléments connectés en parallèle à un noeud central (55), ces éléments étant un dispositif à condensateur (C₁), un dispositif à porte (51) de décharge à la masse, un dispositif à porte (57) de charge connecté à une source de charge, et un dispositif à porte OU (56), le noeud central (55) et le train unique d'impulsions d'horloge étant connectés aux entrées du dispositif à porte OU (56), le train unique d'impulsions d'horloge commandant la décharge du dispositif à condensateur (C₁) à travers le dispositif à porte de décharge (51), le signal de sortie du dispositif à porte OU (56) commandant la charge du dispositif à condensateur (C₁) par l'intermédiaire du dispositif à porte de charge (57) et déterminant aussi le train secondaire d'impulsions.

2. Circuit selon la revendication 1, dans lequel les signaux d'entrée du second ensemble sont tous à un état élevé et sont destinés à charger les lignes (68) qui ne partagent pas les premiers transistors (70) avec les colonnes chargées d'entrée (64, 66).

3. Circuit selon la revendication 1, dans lequel les signaux d'entrée du premier ensemble sont utilisés pour la sélection de l'une des lignes (80, 81, 82), et dans lequel la colonne de sortie au moins est une seule colonne de sortie (85), le circuit agissant comme multiplexeur pour la transmission de l'état d'un signal d'entrée du second ensemble qui est associé à la ligne choisie à la sortie du circuit à réseau logique.

4. Circuit selon la revendication 1, dans lequel la durée du premier état de chaque impulsion d'horloge est légèrement supérieure à la moitié de la période du train unique d'impulsions d'horloge.

5. Circuit selon la revendication 1, dans lequel le premier (63), le second (72), le quatrième (74) et le cinquième (76) dispositif à porte sont ouverts chacun pendant une temps égal à la moitié de la période du train unique d'impulsions d'horloge.

6. Circuit selon la revendication 1, dans lequel le troisième dispositif à porte (73) est ouvert pendant un temps approximativement égal au huitième de la période du train unique d'impulsions d'horloge.

7. Circuit selon la revendication 1, caractérisé en outre en ce que la colonne de sortie au moins comprend un nombre pair de colonnes de sortie (105, 106 ; 110, 111) et le circuit a une série d'éléments de mémoire (108) destinés chacun à conserver des données présentées sous forme complémentaire par une paire de colonnes de sortie connectées par des lignes de données à l'élément respectif de mémoire (108), les signaux transmis par le premier dispositif à porte (90) assurant l'adressage des éléments de mémoire (108) par sélection de lignes (95, 96) connectées à des portes (100, 101 102, 103) des lignes de données des éléments de mémoire (108), chaque paire de colonnes de sortie (105, 106 ; 110, 111) est connectée aux entrées d'un comparateur respectif (128, 129) dont le signal de sortie est transmis par le cinquième dispositif à porte (124, 125), le cinquième dispositif à porte (124, 125) est commandé par le train unique d'impulsions d'horloge et une ligne de commande de lecture-écriture, des signaux d'entrée de données sont transmis au circuit par un sixième dispositif à porte (92) et sont alors transmis sous forme complémentaire dans un septième dispositif à porte (120, 121 122, 123) vers les paires respectives de colonnes de sortie (105, 106 ; 110, 111), le sixième dispositif à porte (92) est commandé par le train unique d'impulsions d'horloge et le septième dispositif à porte (120, 121 ; 122, 123) est commandé par le train unique d'impulsions d'horloge et la ligne de commande de lecture-écriture, le sixième dispositif à porte (92) permet le passage des données introduites pendant le premier état de chaque impulsion d'horloge, et le cinquième (124, 125) et le septième (120, 121, 122, 123) dispositif à porte permettent le passage des sorties et des entrées de données respectivement pendant le second état de chaque impulsion d'horloge suivant l'état de la ligne de commande de lecture-écriture.
